# EUROPEAN PATENT APPLICATION

(11) **EP 4 542 770 A1**
(43) Date of publication of application: **23.04.2025**
(21) Application number: 23870548.7
(22) Date of filing: 20.09.2023
(51) Int. Cl.: H01Q 1/38

(54) **ELECTRONIC DEVICE**

(30) Priority: 01.10.2022 CN 202211214970
(71) Applicant: Huawei Technologies Co., Ltd., Shenzhen, Guangdong 518129 (CN)
(72) Inventor: QIN, Jianghong, Shenzhen, Guangdong 518129 (CN); LI, Xiaofeng, Shenzhen, Guangdong 518129 (CN); ZHANG, Chen, Shenzhen, Guangdong 518129 (CN); WU, Fangbiao, Shenzhen, Guangdong 518129 (CN); WANG, Zhao, Shenzhen, Guangdong 518129 (CN)
(74) Representative: Isarpatent
(86) International application number: PCT/CN2023/120192
(87) International publication number: WO 2024/067316

(57) **Abstract**

Embodiments of this application provide an electronic device, including a circuit board and a first metal mechanical part. The first metal mechanical part and the circuit board are stacked and spaced apart. A clearance area facing inward toward the circuit board is provided on an outer edge of the circuit board. A first radiator is located in the clearance area. One end of the first radiator is electrically connected to a first feed point on the circuit board, and another end of the first radiator is suspended in the clearance area. A second metal mechanical part is located on a periphery of the first metal mechanical part, and at least a part of an orthographic projection that is of the second metal mechanical part and that faces the circuit board is located in the clearance area. One end of each second metal mechanical part is electrically connected to the first metal mechanical part, and a first coupling gap exists between another end of each second metal mechanical part and the first radiator in a thickness direction of the circuit board. In this way, space occupied by an antenna structure in the electronic device can be reduced, and interference or impact on a layout of another component in the electronic device can be avoided.

## Description

This application claims priority to Chinese Patent Application No. 202211214970.2, filed with the China National Intellectual Property Administration on October 1, 2022 and entitled "ELECTRONIC DEVICE", which is incorporated herein by reference in its entirety.

### TECHNICAL FIELD

Embodiments of this application relate to the field of terminal technologies, and in particular, to an electronic device.

### BACKGROUND

With continuous development of communication technologies, radio performance of electronic devices such as mobile phones and computers is increasingly concerned. Therefore, an antenna technology is more widely applied to the electronic devices, and a requirement is increasingly high.

For example, the electronic device is a mobile phone. Generally, different antenna structures are designed at different spatial locations on the mobile phone. Specifically, different resonant antennas may be arranged at different locations in space of the mobile phone based on an actual scenario requirement, to meet antenna requirements in different scenarios. In a related technology, a cavity antenna may be formed in the electronic device. Specifically, in the electronic device, a heat sink is disposed above a printed circuit board (Printed Circuit Board, PCB). A radio frequency coupling probe is disposed above the PCB and near the inside of the heat sink, a plane is disposed on a surface of the heat sink, a horizontal part is provided inside the heat sink and above and near the radio frequency coupling probe, and a winding meander-pattern groove is provided inside the plane. The heat sink is converted into a radiation part of the antenna in a capacitive coupling manner, and dual-band resonance is implemented by using a coupling gap, so that radiation and heat dissipation are integrated. This meets a performance requirement of the antenna, and also implements heat dissipation of the electronic device.

However, in the foregoing design solution, the antenna structure occupies large space in the electronic device, and a layout of another component in the electronic device is prone to being affected.

### SUMMARY

Embodiments of this application provide an electronic device, so that space occupied by an antenna structure in the electronic device can be reduced, and interference or impact on a layout of another component in the electronic device can be avoided.

Embodiments of this application provide an electronic device. The electronic device includes at least a circuit board and a first metal mechanical part. The first metal mechanical part and the circuit board are stacked and spaced apart, and a clearance area facing inward toward the circuit board is provided on an outer edge of the circuit board. The electronic device further includes a first radiator. The first radiator is located in the clearance area. One end of the first radiator is electrically connected to a first feed point on the circuit board, and another end of the first radiator is suspended in the clearance area.

The electronic device further includes a second metal mechanical part. The second metal mechanical part is located on a periphery of the first metal mechanical part, and at least a part of an orthographic projection that is of the second metal mechanical part and that faces the circuit board is located in the clearance area. One end of the second metal mechanical part is electrically connected to the first metal mechanical part, and a first coupling gap exists between another end of the second metal mechanical part and the first radiator in a thickness direction of the circuit board.

According to the electronic device provided in embodiments of this application, the first metal mechanical part and the circuit board are stacked and spaced apart. The clearance area facing inward toward the circuit board is provided on the outer edge of the circuit board. The first radiator is disposed in the clearance area of the circuit board. The one end of the first radiator is electrically connected to the first feed point on the circuit board, and the another end of the first radiator is suspended in the clearance area. In addition, the second metal mechanical part is disposed on the periphery of the first metal mechanical part. The one end of the second metal mechanical part is electrically connected to the first metal mechanical part, and the coupling gap exists between the another end of the second metal mechanical part and the first radiator in the thickness direction of the circuit board, so that a current on the first radiator is coupled to the second metal mechanical part. In this way, embodiments of this application are different from a conventional technology in which an independent antenna structure is designed in the electronic device in that an antenna (namely, the first radiator) is designed by using space on the circuit board, and radiation is generated through gap coupling between the first radiator and the second metal mechanical part, so that space occupied by an antenna structure in the electronic device can be reduced, and interference or impact on a layout of another component in the electronic device can be avoided.

In a possible implementation, an orthographic projection that is of the first metal mechanical part and that faces the circuit board is staggered with the clearance area.

A location of the clearance area on the circuit board is designed to be staggered with the orthographic projection that is of the first metal mechanical part and that faces the circuit board, so that a cavity antenna is not formed between an antenna in the clearance area and the first metal mechanical part. In addition, a distance between the clearance area on the circuit board and the orthographic projection of the first metal mechanical part on the circuit board is limited, so that a loss or a waste of the space on the circuit board caused by an excessively large distance between the clearance area on the circuit board and the orthographic projection of the first metal mechanical part on the circuit board can be avoided, and, a loss and a waste of space in the electronic device can be avoided.

In a possible implementation, the second metal mechanical part includes a longitudinal stub and a first transverse stub that extend on a first plane. The first plane is perpendicular to the thickness direction of the circuit board. One end that is of the longitudinal stub and that extends on the first plane is electrically connected to the first metal mechanical part, and another end that is of the longitudinal stub and that extends on the first plane is connected to the first transverse stub. The first coupling gap is formed between the first transverse stub and the first radiator in the thickness direction of the circuit board.

The longitudinal stub of the second metal mechanical part is electrically connected to the first metal mechanical part, so that an electrical connection between the second metal mechanical part and the first metal mechanical part can be implemented. The first coupling gap is formed between the first transverse stub of the second metal mechanical part and the first radiator in the thickness direction of the circuit board, so that it is ensured that radiation is generated through coupling between the first transverse stub and the first radiator.

In a possible implementation, the electronic device further includes a second radiator. The second radiator is located in the clearance area. One end of the second radiator is electrically connected to a second feed point on the circuit board, and another end of the second radiator is suspended in the clearance area. The first radiator and the second radiator are spaced apart in the clearance area along a length extension direction of the first transverse stub. The length extension direction of the first transverse stub is a length extension direction of an orthographic projection of the first transverse stub on the circuit board.

In a possible implementation, the second metal mechanical part further includes a second transverse stub. Orthographic projections of the first transverse stub and the second transverse stub on the circuit board are respectively located on two sides of an orthographic projection of the longitudinal stub on the circuit board. A second coupling gap exists between the second transverse stub and the second radiator in the thickness direction of the circuit board.

The second transverse stub is designed, so that the second coupling gap can be formed between the second transverse stub and the second radiator in the thickness direction of the circuit board, and it can be ensured that radiation is generated through coupling between the second transverse stub and the second radiator.

In a possible implementation, both the longitudinal stub and the first transverse stub extend in the thickness direction of the circuit board. For example, a specific height is extended in the thickness direction of the circuit board, to meet requirements on radiation performance such as radiation efficiency and bandwidth.

In a possible implementation, the second transverse stub extends in the thickness direction of the circuit board. For example, a specific height is extended in the thickness direction of the circuit board, to meet requirements on radiation performance such as radiation efficiency and bandwidth. It should be understood that extending in the thickness direction of the circuit board does not mean that a thickness direction of the stub is completely consistent with the thickness direction of the circuit board, but means that the thickness direction of the stub and the thickness direction of the circuit board are within a specific acute angle range, for example, within 45 degrees.

In a possible implementation, the electronic device further includes an isolation stub. One end of the isolation stub is located in the clearance area, and the isolation stub extends between the first radiator and the second radiator. Another end of the isolation stub is grounded through the circuit board. A spacing exists between the isolation stub and each of the first radiator and the second radiator.

The isolation stub is designed between the first radiator and the second radiator, so that isolation can be formed between the first radiator and the second radiator, and mutual interference between radiation effect of the first radiator and radiation effect of the second radiator can be avoided or mitigated. In addition, the isolation stub is electrically connected to the circuit board, so that the isolation stub can be grounded.

In a possible implementation, in the thickness direction of the circuit board, the isolation stub is opposite to the longitudinal stub, and a gap exists between the isolation stub and the longitudinal stub. The longitudinal stub and the isolation stub are electrically connected through a conductive structure.

The isolation stub is electrically connected to the longitudinal stub through the conductive structure, so that an electrical connection between the isolation stub and the second metal mechanical part can be implemented.

In a possible implementation, the first radiator includes at least a first radiation stub. One end of the first radiation stub is electrically connected to the first feed point, and another end of the first radiation stub is suspended in the clearance area. The first coupling gap is formed between the first transverse stub and the first radiation stub.

The first radiator is designed to include the first radiation stub. The first feed point is disposed on the circuit board. The first radiation stub is electrically connected to the first feed point, and the first feed point can feed the first radiation stub. In addition, the first coupling gap is formed between the first transverse stub and the first radiation stub, so that it can be ensured that radiation is generated through coupling between the first radiation stub and the first transverse stub of the second metal mechanical part.

In a possible implementation, the first radiator further includes a second radiation stub coupled to the first radiation stub. One end of the second radiation stub is grounded through the circuit board, and another end of the second radiation stub is suspended in the clearance area. The first coupling gap is formed between the first transverse stub and at least one of the first radiation stub and the second radiation stub. A third coupling gap is formed between the first radiation stub and the second radiation stub.

The first radiator is designed to include the first radiation stub and the second radiation stub that are coupled. The first feed point is disposed on the circuit board. The first radiation stub is electrically connected to the first feed point, and the first feed point can feed the first radiation stub. In addition, the first coupling gap is formed between the first transverse stub and the at least one of the first radiation stub or the second radiation stub, so that it can be ensured that radiation is generated through coupling between the first transverse stub of the second metal mechanical part and the at least one of the first radiation stub or the second radiation stub.

In addition, the third coupling gap is formed between the first radiation stub and the second radiation stub, so that it can be ensured that radiation is generated through coupling between the first radiation stub and the second radiation stub.

In a possible implementation, the second radiator includes a third radiation stub. One end of the third radiation stub is electrically connected to the second feed point, and another end of the third radiation stub is suspended in the clearance area. The second coupling gap is formed between the second transverse stub and the third radiation stub.

The second radiator is designed to include the third radiation stub. The second feed point is disposed on the circuit board. The third radiation stub is electrically connected to the second feed point, and the second feed point can feed the third radiation stub. In addition, the second coupling gap is formed between the second transverse stub and the third radiation stub, so that it can be ensured that radiation is generated through coupling between the third radiation stub and the second transverse stub of the second metal mechanical part.

In a possible implementation, the second radiator further includes a fourth radiation stub coupled to the third radiation stub. One end of the fourth radiation stub is grounded through the circuit board, and another end of the fourth radiation stub is suspended in the clearance area. The second coupling gap is formed between the second transverse stub and at least one of the third radiation stub and the fourth radiation stub.

The second radiator is designed to include the third radiation stub and the fourth radiation stub that are coupled. The second feed point is disposed on the circuit board. The third radiation stub is electrically connected to the second feed point, and the second feed point can feed the third radiation stub. In addition, the second coupling gap is formed between the second transverse stub and the at least one of the third radiation stub or the fourth radiation stub, so that it can be ensured that radiation is generated through coupling between the second transverse stub of the second metal mechanical part and the at least one of the third radiation stub or the fourth radiation stub.

In a possible implementation, a fourth coupling gap is formed between the third radiation stub and the fourth radiation stub.

The fourth coupling gap is formed between the third radiation stub and the fourth radiation stub, so that it can be ensured that radiation is generated through coupling between the third radiation stub and the fourth radiation stub.

In a possible implementation, a height of the longitudinal stub in the thickness direction of the circuit board is less than or equal to λ/4, and λ is a wavelength corresponding to a center frequency of a minimum resonance band. The height of the longitudinal stub in the thickness direction of the circuit board is increased, so that isolation of the longitudinal stub between the first radiator and the second radiator can be increased.

In a possible implementation, the transverse stubs are higher than the first metal mechanical part in the thickness direction of the circuit board. Heights of the transverse stubs in the thickness direction of the circuit board are designed to be higher than a height of the first metal mechanical part in the thickness direction of the circuit board, so that the second metal mechanical part can further achieve heat dissipation effect on a basis of heat dissipation performed by the first metal mechanical part.

In a possible implementation, a length of the second transverse stub is greater than a length of the first transverse stub. The length of the second transverse stub is designed to be greater than the length of the first transverse stub, so that frequencies corresponding to the first transverse stub and the second transverse stub are different, to cover different bands of the antenna. In this way, more performance of the antenna can be excited. It should be understood that the lengths of the first transverse stub and the second transverse stub may be considered as lengths of the orthographic projections of the first transverse stub and the second transverse stub on the circuit board.

In a possible implementation, a width of the clearance area in a first direction is greater than or equal to 3 mm. The first direction is a length extension direction of the longitudinal stub, and the length extension direction of the longitudinal stub is a length extension direction of the orthographic projection of the longitudinal stub on the circuit board.

In a possible implementation, the electronic device further includes an electronic component. The electronic component is located between the circuit board and the first metal mechanical part. A concave sink is provided on a side that is of the first metal mechanical part and that faces the circuit board. The electronic component is in contact with a surface that is of the sink and that faces the circuit board.

The sink concave toward the circuit board is provided on the first metal mechanical part, and the electronic component is in contact with the surface that is of the sink and that faces the circuit board, so that an electrical connection path between the electronic component and the first metal mechanical part can be shortened.

In a possible implementation, the electronic device further includes a shielding frame. The shielding frame is located on a periphery of the electronic component, to space the electronic component apart from at least one antenna. A side that is of the shielding frame and that faces the first metal mechanical part is connected to the first metal mechanical part.

The shielding frame is disposed on the periphery of the electronic component, and the shielding frame can space the electronic component apart from the antenna structure, to avoid impact of the electronic component on radiation performance of the antenna, and avoid adverse interference caused by radiation of the antenna to use performance of the electronic component.

In a possible implementation, the first metal mechanical part and the second metal mechanical part are heat sinks, and the electronic component is a heat-emitting component.

The heat sinks are used as the first metal mechanical part and the second metal mechanical part, so that the antenna can be formed by using structures of the heat sinks, to convert the heat sink into a radiation part of the antenna. In this way, radiation and heat dissipation are integrated, which meets a performance requirement of the antenna. In addition, the heat sink can perform heat dissipation on the heat-emitting component, which resolves a heat dissipation problem of the electronic device. Therefore, antenna costs can be reduced to some extent. In addition, embodiments of this application are different from a conventional technology in which grooving needs to be performed on the heat sink to implement dual-band resonance in that the structure of the heat sink is not damaged when the antenna is formed, so that heat dissipation performance of the heat sink is not affected.

In a possible implementation, the electronic device is customer premise equipment. The antenna is formed by using internal space of the customer premise equipment, so that antenna design space in the customer premise equipment can be greatly reduced, and antenna manufacturing costs can be reduced to some extent.

With reference to the accompanying drawings, these and other aspects, implementation forms, and advantages of example embodiments will become apparent based on embodiments described below. However, it should be understood that the specification and the accompanying drawings are merely intended for descriptions and are not intended as definitions of limitations on embodiments of this application. For details, refer to the appended claims. Other aspects and advantages of embodiments of this application are described in the following descriptions, and some aspects are apparent from the descriptions or learned from practices of embodiments of this application. In addition, the aspects and advantages of embodiments of this application may be achieved and obtained by means and combinations specifically pointed out in the appended claims.

### BRIEF DESCRIPTION OF DRAWINGS

FIG. 1 is a diagram of a structure of an electronic device according to an embodiment of this application;
FIG. 2A is a diagram of a structure of an electronic device according to an embodiment of this application;
FIG. 2B is a diagram of a structure of an electronic device according to an embodiment of this application;
FIG. 2C is a diagram of a structure of an electronic device according to an embodiment of this application;
FIG. 3 is a diagram of a structure of an electronic device according to an embodiment of this application;
FIG. 4 is a diagram of a structure of an electronic device according to an embodiment of this application;
FIG. 5 is a top view of an electronic device according to an embodiment of this application;
FIG. 6 is a top view of an electronic device according to an embodiment of this application;
FIG. 7 is a diagram of a partial structure of the electronic device shown in FIG. 6;
FIG. 8 is a diagram of a partial structure of the electronic device shown in FIG. 6;
FIG. 9 is a standing wave curve diagram of a first radiator in an electronic device at 4.95 G according to an embodiment of this application;
FIG. 10 is a current distribution diagram of a first radiator in an electronic device at 4.95 G according to an embodiment of this application;
FIG. 11 is a standing wave curve diagram of a second radiator in an electronic device at 1.82 G according to an embodiment of this application;
FIG. 12 is a current distribution diagram of a second radiator in an electronic device at 1.82 G according to an embodiment of this application;
FIG. 13 is a diagram of a structure of an electronic device according to an embodiment of this application;
FIG. 14 is a diagram of a structure of an electronic device according to an embodiment of this application;
FIG. 15 is a comparison diagram of antenna performance corresponding to different heights of a second metal mechanical part in an electronic device according to an embodiment of this application;
FIG. 16 is an antenna pattern, of a first radiator, obtained when a height of a second metal mechanical part in an electronic device is 0.5 mm according to an embodiment of this application;
FIG. 17 is an antenna pattern, of a first radiator, obtained when a height of a second metal mechanical part in an electronic device is 22.5 mm according to an embodiment of this application;
FIG. 18 is an antenna pattern, of a second radiator, obtained when a height of a second metal mechanical part in an electronic device is 0.5 mm according to an embodiment of this application;
FIG. 19 is an antenna pattern, of a second radiator, obtained when a height of a second metal mechanical part in an electronic device is 22.5 mm according to an embodiment of this application;
FIG. 20 is a diagram of structures of a circuit board, a first radiator, and a second radiator in an electronic device according to an embodiment of this application;
FIG. 21 is a diagram of structures of a circuit board, a first radiator, and a second radiator in an electronic device according to an embodiment of this application;
FIG. 22 is a diagram of a structure of an electronic device according to an embodiment of this application;
FIG. 23 is a diagram of a partial structure of the electronic device shown in FIG. 22;
FIG. 24 is a diagram of a partial structure of the electronic device shown in FIG. 23;
FIG. 25 is a diagram of a partial structure of the electronic device shown in FIG. 23;
FIG. 26 is a standing wave curve diagram of a first radiator and a second radiator in an electronic device according to an embodiment of this application;
FIG. 27 is a current distribution diagram of a first radiator in an electronic device at 3.8 G according to an embodiment of this application;
FIG. 28 is a current distribution diagram of a second radiator in an electronic device at 1.8 G according to an embodiment of this application;
FIG. 29 is a diagram, of a structure, obtained when a height of a longitudinal stub in an electronic device is 1.5 mm according to an embodiment of this application;
FIG. 30 is an antenna pattern obtained when a height of a longitudinal stub in an electronic device is 1.5 mm according to an embodiment of this application;
FIG. 31 is a diagram, of a structure, obtained when a height of a longitudinal stub in an electronic device is 13.5 mm according to an embodiment of this application; and
FIG. 32 is an antenna pattern obtained when a height of a longitudinal stub in an electronic device is 13.5 mm according to an embodiment of this application.

### Reference numerals:

100: electronic device; 110: circuit board; 111: clearance area;
111a: support plate; 112: first feed point; 113: second feed point;
120: first metal mechanical part; 131: first radiator; 1311: first radiation stub;
1312: second radiation stub; 132: second radiator; 1321: third radiation stub;
133: isolation stub; 1331: spacing; 1332: gap;
140: second metal mechanical part; 141: longitudinal stub; 142: first transverse stub;
143: second transverse stub; 151: first coupling gap; 152: second coupling gap;
153: third coupling gap; 160: conductive structure; 170: shielding frame;
L1: thickness direction of the circuit board; L2: first direction; D1: first width;
D2: second width; H1: first gap; H2: second gap;
H3: first height; H4: second height.

### DESCRIPTION OF EMBODIMENTS

Terms used in implementations of this application are merely used to explain specific embodiments of this application, but are not intended to limit this application. The following describes implementations of embodiments of this application in detail with reference to the accompanying drawings.

Embodiments of this application provide an electronic device, which may include but is not limited to a smart speaker, a smart lock, a mobile phone, a tablet computer, a notebook computer, a router, customer premise equipment (Customer Premise Equipment, CPE), an internet of things (The Internet of Things, IOT) device, an ultra-mobile personal computer (ultra-mobile personal computer, UMPC), a handheld computer, a walkie-talkie, a netbook, a point of sales (Point of sales, POS) machine, a personal digital assistant (personal digital assistant, PDA), a wearable device, a virtual reality device, a wireless USB flash drive, a Bluetooth speaker/headset, or a mobile or fixed terminal with an antenna, such as an in-vehicle front-mounted device, an event data recorder, or a security device.

In embodiments of this application, an example in which the CPE is the foregoing electronic device is used for description.

With popularization of a 5G mobile communication technologies, specifications of a terminal product such as the CPE are gradually improved. For example, to further increase a function that can be implemented by the CPE, a quantity of internal antennas of the CPE is greatly increased. However, due to a limitation of a size of entire equipment, an overall layout in the product becomes increasingly compact, mutual impact between antennas is increasingly large, and antenna performance deteriorates accordingly. At the same time, due to the improvement of the specifications, power consumption of the product increases significantly. To resolve a heat emission problem, a volume of a heat sink increases accordingly, and antenna space is further compressed. Both the increase of the quantity of antennas and the increase of the volume of the heat sink cause an increase of costs. A loss of the antenna performance and the increase of the costs due to high specifications and a small size are one of pain point problems to be resolved by the current product.

Specifically, in a related technology, in the CPE, the heat sink is disposed above a printed circuit board (Printed Circuit Board, PCB). A radio frequency coupling probe is disposed above the PCB at a part near the heat sink, a plane is disposed on a surface of the heat sink, a horizontal part is provided inside the heat sink and above and near the radio frequency coupling probe, and a winding meander-pattern groove is provided inside the plane. The heat sink is converted into a radiation part of the antenna in a capacitive coupling manner, and dual-band resonance is implemented by using a coupling gap. However, in this solution, an antenna structure occupies large space in the CPE, and a layout of another component in the CPE is prone to being affected.

Based on this, embodiments of this application provide an electronic device. The electronic device may be, for example, CPE. In the electronic device, at least one clearance area facing inward toward a circuit board is provided on an outer edge of the circuit board. An antenna is disposed in the clearance area of the circuit board. One end of the antenna is electrically connected to a feed point on the circuit board, and another end of the antenna is suspended in the clearance area. In addition, at least one second metal mechanical part is disposed on a periphery of a first metal mechanical part. One end of each second metal mechanical part is electrically connected to an outer edge of the first metal mechanical part, and a coupling gap exists between another end of each second metal mechanical part and the antenna in a thickness direction of the circuit board, so that a current on the antenna is coupled to the second metal mechanical part. In this way, embodiments of this application are different from a conventional technology in which an independent antenna structure is designed in the electronic device in that the antenna is designed by using space on the circuit board, and radiation is generated through coupling between the antenna and the second metal mechanical part, so that space occupied by an antenna structure in the electronic device can be reduced, and interference or impact on a layout of another component in the electronic device can be avoided.

It should be noted that the antenna provided in this application is applicable to an electronic device that uses one or more of the following MIMO (Multi-in Multi-out, multi-in multi-out) communication technologies, for example, a long term evolution (long term evolution, LTE) communication technology, a Wi-Fi communication technology, a 5G communication technology, a SUB-6G communication technology, and another future MIMO communication technology. The MIMO communication technology is an antenna system in which a plurality of antennas are used at both a transmitting end and a receiving end, to form a plurality of channels between transmission and reception, which has extremely high spectrum utilization efficiency.

It may be understood that a structure shown in embodiments of this application does not constitute a specific limitation on the CPE. In some other embodiments of this application, the CPE may include more or fewer components, some components may be combined, some components may be split, or different component arrangements may be used.

The following uses different embodiments as examples to describe a specific structure of the electronic device with reference to the accompanying drawings (where the following embodiments do not highlight a requirement of a communication network, and only describe an operating feature of the antenna based on a magnitude of a frequency).

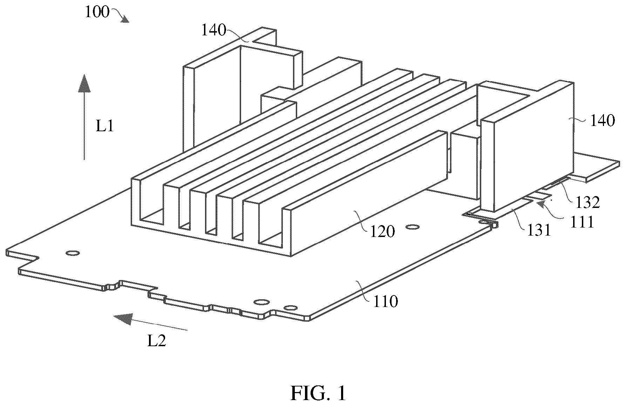

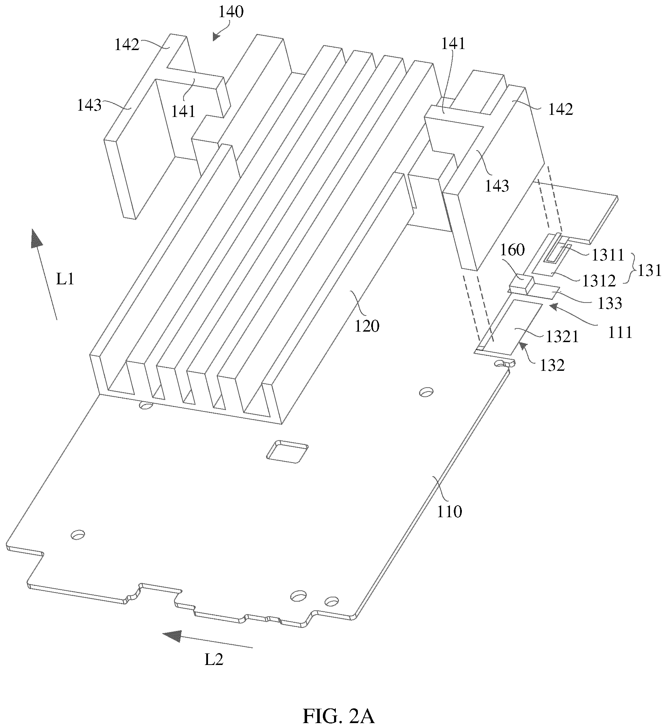

As shown in FIG. 1 and FIG. 2A, embodiments of this application provide an electronic device 100. The electronic device 100 may be, for example, CPE, a speaker, a mobile phone, or a computer. Specifically, as shown in FIG. 1 and FIG. 2A, the electronic device 100 may include at least: a circuit board 110 and a first metal mechanical part 120. The first metal mechanical part 120 and the circuit board 110 are stacked and spaced apart. At least one clearance area 111 is provided on an outer edge of the circuit board 110, and the clearance area 111 is concave inward toward the circuit board 110.

It may be understood that the clearance area 111 is a non-metal region on the circuit board 110. In an embodiment, the clearance area 111 may also be referred to as a hollow region.

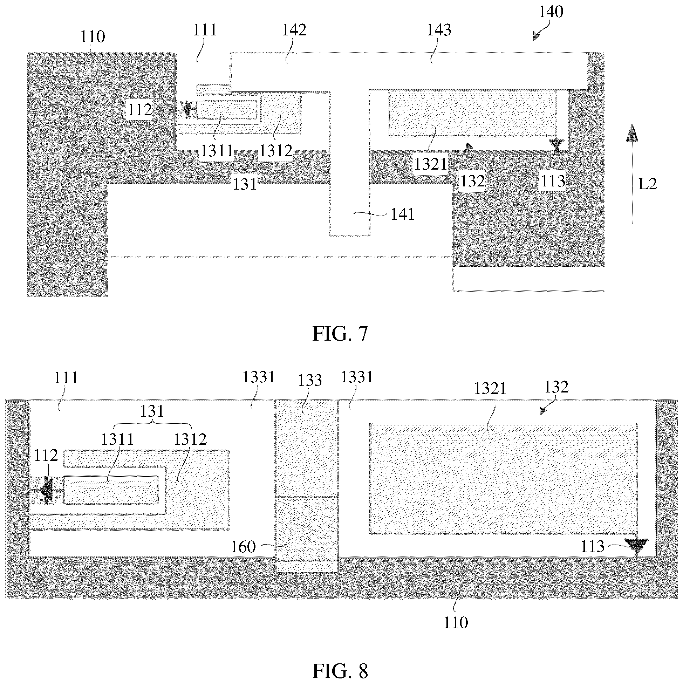

The electronic device 100 may further include a first radiator 131. The first radiator 131 may be located in the clearance area 111. One end of the first radiator 131 is electrically connected to a first feed point 112 (as shown in FIG. 7) on the circuit board 110, and another end of the first radiator 131 is suspended in the clearance area 111.

It may be understood that "being suspended" means being not connected to another conductive structure. In other words, there is no direct electrical connection relationship between the another end of the first radiator 131 and another conductive structure in the electronic device 100.

It may be understood that the clearance area 111 may be used as a clearance area, and the first radiator 131 may be a printed pattern (pattern), a wire, a conductive plate, a conductive strip, or the like. This is not limited in embodiments of this application.

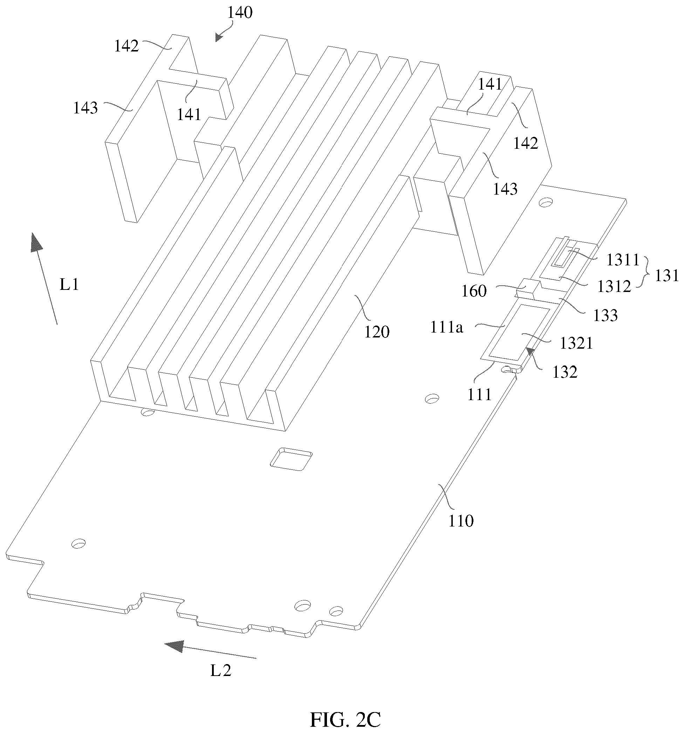

In addition, in a possible implementation, with reference to FIG. 2C, a support plate 111a may be further disposed in the clearance area 111. In an embodiment, one side of the support plate 111a is connected to the circuit board 110, and another side of the support plate 111a is connected to the first radiator 131 and a second radiator 132. In an embodiment, the support plate 111a and the circuit board 110 are formed by a same substrate. The support plate 111a is used to support the first radiator 131 and the second radiator 132, to prevent the first radiator 131 and the second radiator 132 from being detached from the clearance area 111. The support plate 111a may be made of an insulating material.

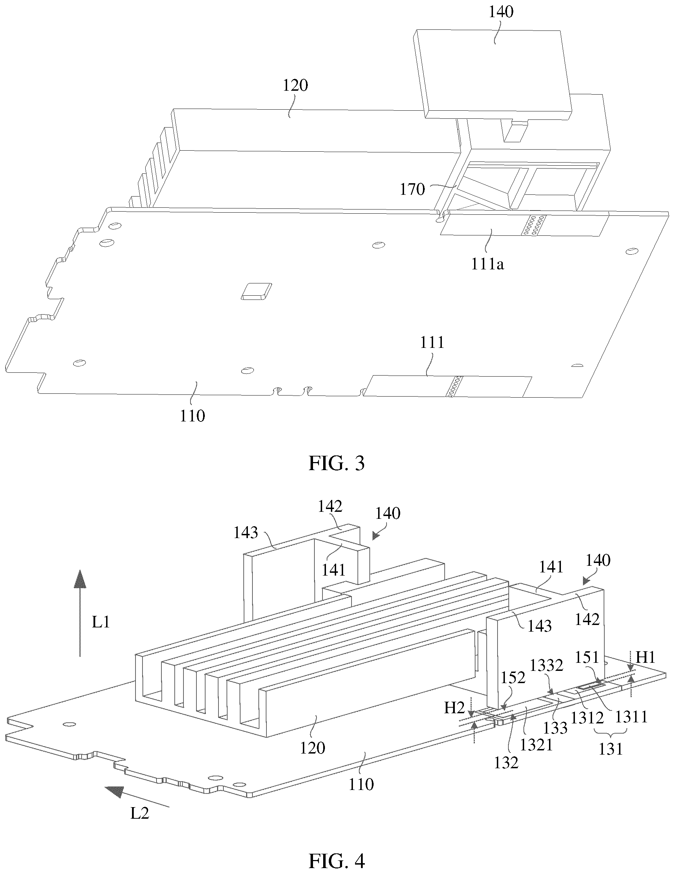

In addition, as shown in FIG. 3, the electronic device 100 may further include: a second metal mechanical part 140. The second metal mechanical part 140 may be located on a periphery of the first metal mechanical part 120, and at least a part of an orthographic projection that is of the second metal mechanical part 140 and that faces the circuit board 110 may be located in the clearance area 111. One end of each second metal mechanical part 140 is electrically connected to the first metal mechanical part 120, and a first coupling gap 151 exists between another end of each second metal mechanical part 140 and the first radiator 131 in a thickness direction L1 of the circuit board, so that a current on the first radiator 131 is coupled to the second metal mechanical part 140.

In this way, embodiments of this application are different from a conventional technology in which an independent antenna structure is designed in the electronic device 100 in that an antenna is designed by using space on the circuit board 110, and radiation is generated through coupling between the antenna (for example, the first radiator 131) and the second metal mechanical part 140, so that space occupied by an antenna structure in the electronic device 100 can be reduced, and interference or impact on a layout of another component in the electronic device 100 can be avoided. In other words, miniaturized broadband coverage can be implemented between the second metal mechanical part 140 and the first radiator 131 on a premise that omnidirectional coverage of a pattern is ensured. In other words, in embodiments of this application, high radiation performance for the electronic device 100 can be implemented with a small size and a high heat dissipation capability.

In embodiments of this application, the first metal mechanical part 120 and the second metal mechanical part 140 may be heat sinks, and an electronic component may be a heat-emitting component. The electronic component is in contact with a surface that is of the first metal mechanical part 120 and that faces the circuit board 110. In this case, the first metal mechanical part 120 can provide good heat dissipation effect for the electronic component. Certainly, in some other embodiments, the first metal mechanical part 120 and the second metal mechanical part 140 may alternatively be of metal structures such as metal housings. This is not limited in embodiments of this application.

It should be noted that, in embodiments of this application, when the first metal mechanical part 120 is a heat sink, the first metal mechanical part 120 may be, for example, a plate heat sink, and a material used for the plate heat sink may be aluminum.

The heat sinks are used as the first metal mechanical part 120 and the second metal mechanical part 140, so that the antenna can be formed by using structures of the heat sinks. The second metal mechanical part 140 provides both radiation and heat dissipation functions, to convert the heat sink into a radiation part of the antenna. In this way, radiation and heat dissipation are integrated, which meets a performance requirement of the antenna. In addition, the heat sink can perform heat dissipation on the heat-emitting component, which resolves a heat dissipation problem of the electronic device 100. Therefore, antenna costs can be reduced to some extent.

To some extent, the antenna may be implemented in limited design space. This effectively reduces antenna design space in the electronic device 100. For example, the electronic device 100 is CPE. In embodiments of this application, the antenna is formed by using internal space of the CPE, so that antenna design space in the CPE can be greatly reduced, and antenna manufacturing costs can be reduced to some extent.

In addition, embodiments of this application are different from a conventional technology in which grooving needs to be performed on the heat sink to implement dual-band resonance in that grooving does not need to be additionally performed on the heat sink for the antenna provided in embodiments of this application. Therefore, the structure of the heat sink is not damaged when the antenna is formed, so that heat dissipation performance of the heat sink is not affected.

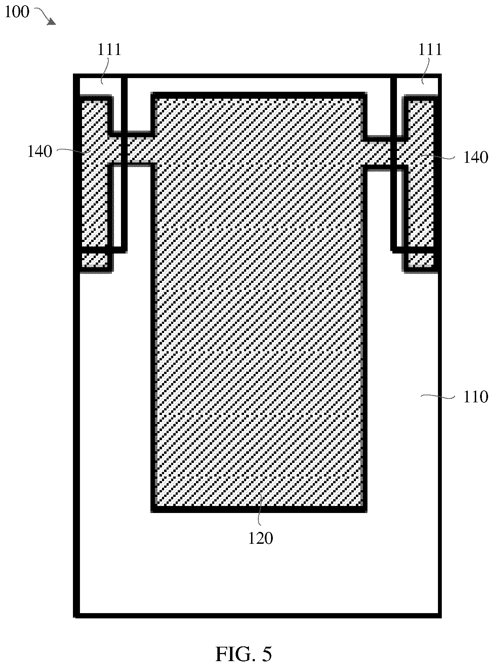

It may be understood that, in embodiments of this application, as shown in FIG. 4 or FIG. 5, an orthographic projection that is of the first metal mechanical part 120 and that faces the circuit board 110 may be staggered with the clearance area 111. A location of the clearance area 111 on the circuit board 110 is designed to be staggered with the orthographic projection of the first metal mechanical part 120 on the circuit board 110, so that an antenna is not formed between an antenna in the clearance area 111 and the first metal mechanical part 120.

In addition, a distance between an outer edge of the orthographic projection of the first metal mechanical part 120 on the circuit board 110 and the clearance area 111 may be less than or equal to 10 mm. A distance between the clearance area 111 on the circuit board 110 and the orthographic projection of the first metal mechanical part 120 on the circuit board 110 is limited, so that a loss or a waste of the space on the circuit board 110 caused by an excessively large distance between the clearance area 111 on the circuit board 110 and the orthographic projection of the first metal mechanical part 120 on the circuit board 110 can be avoided, and a loss and a waste of space in the electronic device 100 can be avoided.

It should be noted that the distance between the outer edge of the orthographic projection of the first metal mechanical part 120 on the circuit board 110 and the clearance area 111 may be 10 mm, 9 mm, 8 mm, 7 mm, 6 mm, 5 mm, 4 mm, 3 mm, 2 mm, 1 mm, or an intermediate value of any two adjacent values. This is not limited in embodiments of this application.

Certainly, the distance between the outer edge of the orthographic projection of the first metal mechanical part 120 on the circuit board 110 and the clearance area 111 may be specifically set flexibly according to a requirement of an actual application scenario, for example, may be set based on an actual antenna form and an actual frequency. This is not limited in embodiments of this application.

As shown in FIG. 4, in embodiments of this application, the second metal mechanical part 140 may include a longitudinal stub 141 and a first transverse stub 142 that extend on a first plane. The first plane is perpendicular to the thickness direction of the circuit board. One end that is of the longitudinal stub 141 and that extends on the first plane is electrically connected to the first metal mechanical part 120, and another end that is of the longitudinal stub 141 and that extends on the first plane is connected to the first transverse stub 142. The first coupling gap 151 may be formed between the first transverse stub 142 and the first radiator 131 in the thickness direction L1 of the circuit board.

The longitudinal stub 141 of the second metal mechanical part 140 is electrically connected to the first metal mechanical part 120, so that an electrical connection between the second metal mechanical part 140 and the first metal mechanical part 120 can be implemented. The first coupling gap 151 is formed between the first transverse stub 142 of the second metal mechanical part 140 and the corresponding first radiator 131 in the thickness direction L1 of the circuit board, so that it can be ensured that radiation is generated through coupling between the first transverse stub 142 and the corresponding first radiator 131.

In an embodiment, both the longitudinal stub 141 and the first transverse stub 142 extend in the thickness direction of the circuit board. For example, a specific height is extended in the thickness direction of the circuit board.

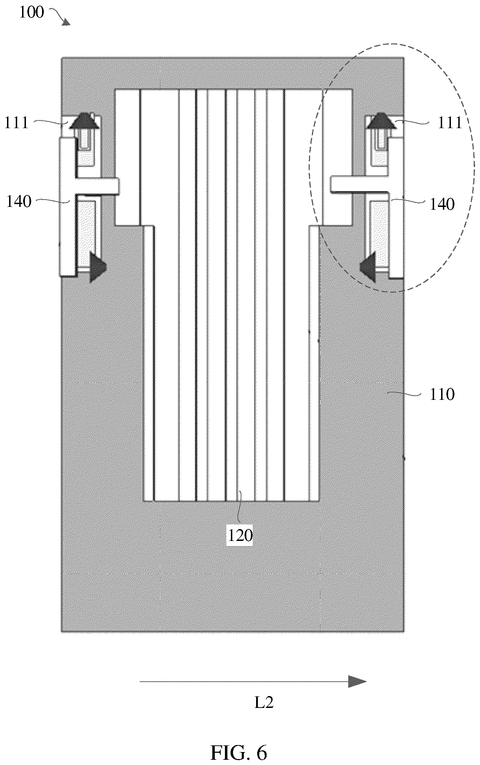

It may be understood that, as shown in FIG. 6 to FIG. 8, in embodiments of this application, the electronic device 100 may further include the second radiator 132. The second radiator 132 may be located in the clearance area 111. In addition, one end of the second radiator 132 is electrically connected to a second feed point 113 on the circuit board 110, and another end of the second radiator 132 is suspended in the clearance area 111. The first radiator 131 and the second radiator 132 are spaced apart in the clearance area 111 along a length extension direction of the first transverse stub 142, and the length extension direction of the first transverse stub 142 is a length extension direction of an orthographic projection of the first transverse stub 142 on the circuit board.

In addition, the second metal mechanical part 140 may further include a second transverse stub 143 extending on the first plane. Orthographic projections of the first transverse stub 142 and the second transverse stub 143 on the circuit board may be respectively located on two sides of an orthographic projection of the longitudinal stub 141 on the circuit board. In this case, the first coupling gap 151 is formed between the first transverse stub 142 and the first radiator 131 in the thickness direction L1 of the circuit board, and a second coupling gap 152 is formed between the second transverse stub 143 and the second radiator 132 in the thickness direction L1 of the circuit board (as shown in FIG. 4).

In an embodiment, the second transverse stub 143 extends in the thickness direction of the circuit board. For example, a specific height is extended in the thickness direction of the circuit board.

It should be understood that extending in the thickness direction of the circuit board does not mean that a thickness direction of the stub is completely consistent with the thickness direction of the circuit board, but means that the thickness direction of the stub and the thickness direction of the circuit board are within a specific acute angle range, for example, within 45 degrees.

It should be noted that, in embodiments of this application, a size of the first coupling gap 151 (namely, a first gap H1) may be 0.05 mm, 0.1 mm, 0.15 mm, 0.2 mm, 0.25 mm, or an intermediate value between any two adjacent values, and a size of the second coupling gap 152 (namely, a second gap H2) may be 0.05 mm, 0.1 mm, 0.15 mm, 0.2 mm, 0.25 mm, or an intermediate value between any two adjacent values. This is not limited in embodiments of this application.

Two transverse stubs (that is, the first transverse stub 142 and the second transverse stub 143) are designed in the second metal mechanical part 140, and two antennas (that is, the first radiator 131 and the second radiator 132) are designed in the clearance area 111 of the circuit board 110, so that a broadband dual-antenna co-body design can be implemented in an extremely small clearance. In this way, the first coupling gap 151 can be formed between the first transverse stub 142 and the first radiator 131 in the two antennas in the thickness direction L1 of the circuit board, so that it can be ensured that radiation is generated through coupling between the first transverse stub 142 and the first radiator 131. The second coupling gap 152 can be formed between the second transverse stub 143 and the second radiator 132 in the two antennas in the thickness direction L1 of the circuit board, so that it can be ensured that radiation is generated through coupling between the second transverse stub 143 and the second radiator 132.

In addition, in some embodiments, still as shown in FIG. 4, heights of the first transverse stub 142 and the second transverse stub 143 in the thickness direction L1 of the circuit board may be higher than a height of the first metal mechanical part 120 in the thickness direction L1 of the circuit board. The heights of the first transverse stub 142 and the second transverse stub 143 in the thickness direction L1 of the circuit board are designed to be higher than the height of the first metal mechanical part 120 in the thickness direction L1 of the circuit board, so that the second metal mechanical part 140 can further achieve heat dissipation effect on a basis of heat dissipation performed by the first metal mechanical part 120.

In addition, in a case, the second metal mechanical part 140 is designed to include the longitudinal stub 141, the first transverse stub 142, and the second transverse stub 143 that extend on the first plane. The first plane is perpendicular to the thickness direction of the circuit board. In an embodiment, the longitudinal stub 141, the first transverse stub 142, and the second transverse stub 143 jointly form a T-shaped structure shown in FIG. 7. For example, the orthographic projections of the longitudinal stub 141, the first transverse stub 142, and the second transverse stub 143 on the circuit board form a T-shaped structure. In this case, a two-dimensional antenna structure can be extended to a three-dimensional structure in embodiments of this application, to implement a miniaturization design of the antenna. In addition, the second metal mechanical part 140 of the T-shaped structure uses a height of the second metal mechanical part 140 in the thickness direction L1 of the circuit board in a coupling manner, so that two-dimensional current distribution can be extended to three-dimensional current distribution, to help implement good regulation and control of the pattern.

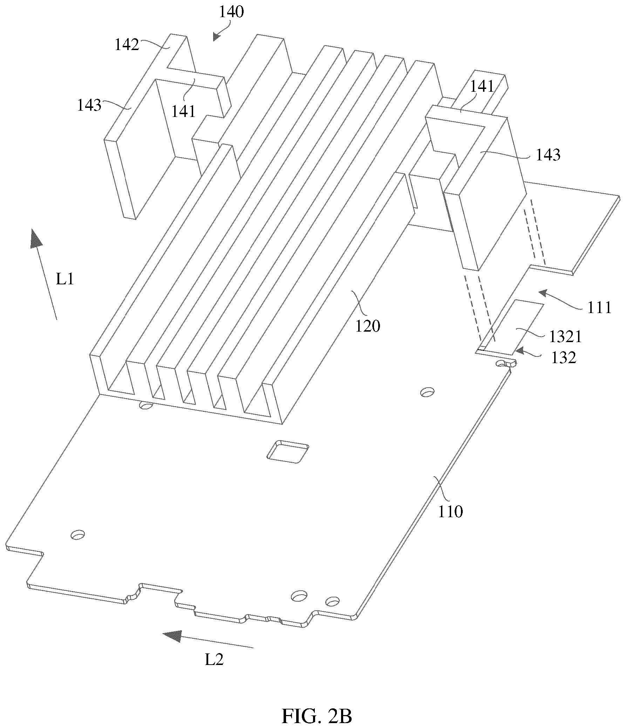

Certainly, in some other embodiments, the second metal mechanical part 140 may be designed to include the longitudinal stub 141 and the first transverse stub 142, and the longitudinal stub 141 and the first transverse stub 142 jointly form an L-shaped structure (not shown in the figure). Alternatively, the second metal mechanical part 140 may be designed to include the longitudinal stub 141 and the second transverse stub 143, and the longitudinal stub 141 and the second transverse stub 143 jointly form an L-shaped structure (as shown in FIG. 2B). This is not limited in embodiments of this application. In an embodiment, the L-shaped structure may be understood as an L-shaped structure formed by an orthographic projection on the circuit board.

As shown in FIG. 7, in embodiments of this application, a length of the second transverse stub 143 may be greater than a length of the first transverse stub 142. The length of the second transverse stub 143 is designed to be greater than the length of the first transverse stub 142, so that frequencies corresponding to the first transverse stub 142 and the second transverse stub 143 are different, to cover different bands of the antenna. In this way, more performance of the antenna can be excited. In an embodiment, the lengths of the first transverse stub 142 and the second transverse stub 143 may be considered as lengths of the orthographic projections of the first transverse stub 142 and the second transverse stub 143 on the circuit board.

In embodiments of this application, as shown in FIG. 8, the electronic device 100 may further include an isolation stub 133. One end of the isolation stub 133 is located in the clearance area 111. The isolation stub 133 extends between the first radiator 131 and the second radiator 132. Another end of the isolation stub 133 is grounded through the circuit board 110. In addition, a spacing 1331 may exist between the isolation stub 133 and each of the first radiator 131 and the second radiator 132.

It may be understood that, that the isolation stub 133 extends between the first radiator 131 and the second radiator 132 may include that the isolation stub 133 is located between one end of the first radiator 131 and one end of the second radiator 132, or may include that the isolation stub 133 passes through between one end of the first radiator 131 and one end of the second radiator 132, and extends outward.

The isolation stub 133 is designed between the first radiator 131 and the second radiator 132, so that isolation can be formed between the first radiator 131 and the second radiator 132, and mutual interference between radiation effect of the first radiator 131 and radiation effect of the second radiator 132 can be avoided or mitigated. In addition, the isolation stub 133 is electrically connected to the circuit board 110, so that the isolation stub can be grounded.

In the thickness direction L1 of the circuit board, the isolation stub 133 may be opposite to the longitudinal stub 141, and a gap 1332 may exist between the isolation stub 133 and the longitudinal stub 141. The longitudinal stub 141 and the isolation stub 133 are electrically connected through a conductive structure 160. The isolation stub is electrically connected to the longitudinal stub 141 through the conductive structure 160, so that an electrical connection between the isolation stub and the second metal mechanical part 140 can be implemented.

In embodiments of this application, the conductive structure 160 may be conductive foam, or the conductive structure 160 may be conductive adhesive, or the conductive structure 160 may be another conductive component such as a metal dome. The conductive foam, the conductive adhesive, and the metal dome can all be used to electrically connect the longitudinal stub 141 and the isolation stub 133.

It should be noted that, in embodiments of this application, a specific structure of the first radiator 131 may include but is not limited to the following two possible implementations.

In a possible implementation, the first radiator 131 may include at least a first radiation stub 1311. The first feed point 112 is disposed on the circuit board 110. One end of the first radiation stub 1311 is electrically connected to the first feed point 112, and another end of the first radiation stub 1311 is suspended in the clearance area 111. In addition, the first coupling gap 151 may be formed between the first transverse stub 142 and the first radiation stub 1311.

In this way, the first radiation stub 1311 is electrically connected to the first feed point 112, and the first feed point 112 can feed the first radiation stub 1311. In addition, the first coupling gap 151 is formed between the first transverse stub 142 and the first radiation stub 1311, so that it can be ensured that radiation is generated through coupling between the first radiation stub 1311 and the first transverse stub 142 of the second metal mechanical part 140.

In another possible implementation, as shown in FIG. 8, the first radiator 131 may include a first radiation stub 1311 and a second radiation stub 1312. The second radiation stub 1312 is coupled to the first radiation stub 1311. The first feed point 112 is disposed on the circuit board 110. One end of the first radiation stub 1311 is electrically connected to the first feed point 112, and another end of the first radiation stub 1311 is suspended in the clearance area 111. One end of the second radiation stub 1312 is electrically connected to the circuit board 110, and another end of the second radiation stub 1312 is suspended in the clearance area 111.

In addition, the first coupling gap 151 may be formed between the first transverse stub 142 and at least one of the first radiation stub 1311 and the second radiation stub 1312. For example, the first coupling gap 151 may be formed between the first transverse stub 142 and the first radiation stub 1311, or the first coupling gap 151 may be formed between the first transverse stub 142 and the second radiation stub 1312, or the first coupling gap 151 may be formed between the first transverse stub 142 and the first radiation stub 1311 and the second radiation stub 1312.

In this way, the first radiation stub 1311 is electrically connected to the first feed point 112, and the first feed point 112 can feed the first radiation stub 1311. In addition, the first coupling gap 151 is formed between the first transverse stub 142 and the at least one of the first radiation stub 1311 or the second radiation stub 1312, so that it can be ensured that radiation is generated through coupling between the first transverse stub 142 of the second metal mechanical part 140 and the at least one of the first radiation stub 1311 or the second radiation stub 1312.

In some embodiments, the first feed point 112 may be disposed on the second metal mechanical part 140. In this case, the first feed point 112 feeds the second metal mechanical part 140, and the first radiator 131 and the second radiator 132 are used as a coupled radiator. When the second metal mechanical part 140 is fed, the antenna may be a monopole antenna, a loop antenna (LOOP), an inverted F-type antenna (Inverted F-shaped Antenna, IFA), or a planar inverted F-type antenna (Planar Inverted F-shaped Antenna, planar inverted F-type antenna).

It may be understood that, in embodiments of this application, the first feed point 112 may be a metal dome, a probe, a conductive cable, or the like. In this way, the first radiation stub 1311 may be fed by using the metal dome, the probe, the conductive cable, or the like. It should be noted that a specific forming manner of the first feed point 112 is not limited in embodiments of this application, and is not limited to the foregoing examples, provided that the first feed point 112 can be used for a feed connection.

In addition, in embodiments of this application, there may be one, two, three, or more first feed points 112 corresponding to the first radiation stub 1311. In other words, the first radiation stub 1311 may be fed by using one first feed point 112, or the first radiation stub 1311 may be fed by using two first feed points 112 at the same time, or the first radiation stub 1311 may be fed by using three first feed points 112 at the same time, or the first radiation stub 1311 may be fed by using more first feed points 112 at the same time. This is not limited in embodiments of this application.

In some embodiments, as shown in FIG. 8, the second radiation stub 1312 may be located on a periphery of the first radiation stub 1311. The second radiation stub 1312 is disposed on the periphery of the first radiation stub 1311, so that a coupling area between the second radiation stub 1312 and the first radiation stub 1311 can be increased. In addition, the second radiation stub 1312 is disposed around the periphery of the first radiation stub 1311, so that the first radiator 131 can be omnidirectionally designed. In this way, the first radiator 131 can implement omnidirectional radiation on a horizontal plane, and regulation and control of a pattern of the first radiator 131 and isolation optimization can be implemented through adjustment of a size of the first transverse stub 142.

In addition, a third coupling gap 153 may be formed between the first radiation stub 1311 and the second radiation stub 1312, so that it can be ensured that radiation is generated through coupling between the first radiation stub 1311 and the second radiation stub 1312.

Similarly, it should be noted that, in embodiments of this application, a specific structure of the second radiator 132 may include but is not limited to the following two possible implementations.

In a possible implementation, as shown in FIG. 7 and FIG. 8, the second radiator 132 may include a third radiation stub 1321. The second feed point 113 is disposed on the circuit board 110. One end of the third radiation stub 1321 is electrically connected to the second feed point 113, and another end of the third radiation stub 1321 is suspended in the clearance area 111. In addition, the second coupling gap 152 may be formed between the second transverse stub 143 and the third radiation stub 1321.

In this way, the third radiation stub 1321 is electrically connected to the second feed point 113, and the second feed point 113 can feed the third radiation stub 1321. In addition, the second coupling gap 152 is formed between the second transverse stub 143 and the third radiation stub 1321, so that it can be ensured that radiation is generated through coupling between the third radiation stub 1321 and the second transverse stub 143 of the second metal mechanical part 140.

In another possible implementation, the second radiator 132 may include a third radiation stub 1321 and a fourth radiation stub (not shown in the figure). The fourth radiation stub is coupled to the third radiation stub 1321. The second feed point 113 is disposed on the circuit board 110. One end of the third radiation stub 1321 is electrically connected to the second feed point 113, and another end of the third radiation stub 1321 is suspended in the clearance area 111. One end of the fourth radiation stub is electrically connected to the circuit board 110, and another end of the fourth radiation stub is suspended in the clearance area 111.

In addition, the second coupling gap 152 may be formed between the second transverse stub 143 and at least one of the third radiation stub 1321 and the fourth radiation stub. For example, the second coupling gap 152 may be formed between the second transverse stub 143 and the third radiation stub 1321, or the second coupling gap 152 may be formed between the second transverse stub 143 and the fourth radiation stub, or the second coupling gap 152 may be formed between the second transverse stub 143 and the third radiation stub 1321 and the fourth radiation stub.

In this way, the third radiation stub 1321 is electrically connected to the second feed point 113, and the second feed point 113 can feed the third radiation stub 1321. In addition, the second coupling gap 152 is formed between the second transverse stub 143 and the at least one of the third radiation stub 1321 or the fourth radiation stub, so that it can be ensured that radiation is generated through coupling between the second transverse stub 143 of the second metal mechanical part 140 and the at least one of the third radiation stub 1321 or the fourth radiation stub.

It may be understood that, in embodiments of this application, the second feed point 113 may be a metal dome, a probe, a conductive cable, or the like. In this way, the third radiation stub 1321 may be fed by using the metal dome, the probe, the conductive cable, or the like. It should be noted that a specific forming manner of the second feed point 113 is not limited in embodiments of this application, and is not limited to the foregoing examples, provided that the second feed point 113 can be used for a feed connection.

In addition, in embodiments of this application, there may be one, two, three, or more second feed points 113 corresponding to the third radiation stub 1321. In other words, the third radiation stub 1321 may be fed by using one second feed point 113, or the third radiation stub 1321 may be fed by using two second feed points 113 at the same time, or the third radiation stub 1321 may be fed by using three second feed points 113 at the same time, or the third radiation stub 1321 may be fed by using more second feed points 113 at the same time. This is not limited in embodiments of this application.

In some embodiments, the fourth radiation stub may be located on a periphery of the third radiation stub 1321. The fourth radiation stub is disposed on the periphery of the third radiation stub 1321, so that a coupling area between the fourth radiation stub and the third radiation stub 1321 can be increased. In addition, the fourth radiation stub is disposed around the periphery of the third radiation stub 1321, so that the second radiator 132 can be omnidirectionally designed. In this way, the second radiator 132 can implement omnidirectional radiation on a horizontal plane, and regulation and control of a pattern of the second radiator 132 and isolation optimization can be implemented through adjustment of a size of the second transverse stub 143.

In addition, a fourth coupling gap (not shown in the figure) may be formed between the third radiation stub 1321 and the fourth radiation stub. In this way, it can be ensured that radiation is generated through coupling between the third radiation stub 1321 and the fourth radiation stub.

In an actual application scenario, the first radiator 131 and the second radiator 132 may be of structures shown in FIG. 7 and FIG. 8. The first radiator 131 may include the first radiation stub 1311 and the second radiation stub 1312, and the first radiator 131 can cover 2.2 GHz to 5 GHz. The second radiator 132 may include the third radiation stub 1321, and the second radiator 132 can cover 1.7 GHz to 2.7 GHz.

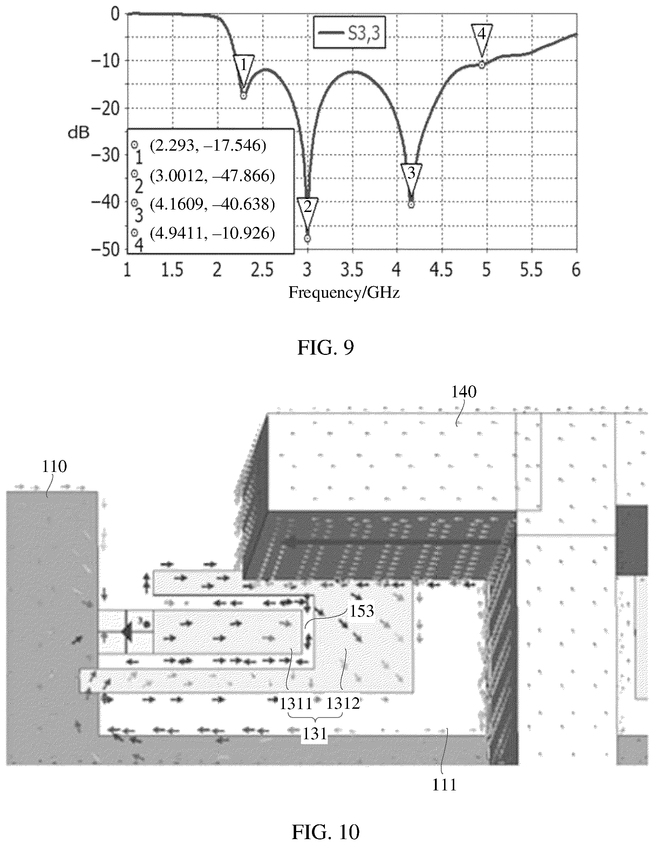

It should be noted herein that, in some embodiments, FIG. 9 and FIG. 10 show a standing wave of the first radiator 131 and a current distribution diagram of the first radiator 131 at 4.95 GHz. As partial radiators of the first radiator 131, the first transverse stub 142 and the longitudinal stub 141 of the second metal mechanical part 140 can generate a new λ/4 fundamental mode at 4.95 GHz, so that bandwidth of the first radiator 131 can be extended.

In this embodiment of this application, a simulation test is performed on operating modes of four resonance points 2.3 GHz, 3 GHz, 4.2 GHz, and 4.95 GHz in FIG. 9. For example, currents of a band including 2.3 GHz, a band including 3 GHz, a band including 4.2 GHz, and a band including 4.95 GHz are separately fed into the first feed point, and then current distribution on each radiation stub is observed. It is obtained through the simulation test that, at the resonance point 2.3 GHz, there is mainly a left-hand mode generated by the second radiation stub 1312, and an electrical length of the second radiation stub 1312 may range from λ/8 to λ/4. At the resonance point 3 GHz, there is mainly a λ/4 fundamental mode generated by the first radiation stub 1311, and an electrical length of the first radiation stub 1311 is λ/4. At the resonance point 4.2 GHz, there is mainly a third-order mode generated by the first radiation stub 1311 and the second radiation stub 1312, and a sum of the electrical lengths of the first radiation stub 1311 and the second radiation stub 1312 ranges from 3λ/8 to 3λ/4. At the resonance point 4.95 GHz, there is mainly a λ/4 fundamental mode generated by the first transverse stub 142 and the longitudinal stub 141. A sum of electrical lengths of the first transverse stub 142 and the longitudinal stub 141 is λ/4, where λ is a wavelength corresponding to a center frequency of a resonance frequency. For example, in this embodiment of this application, the center frequency of the resonance frequency is 3 GHz, and therefore, λ is 3 GHz.

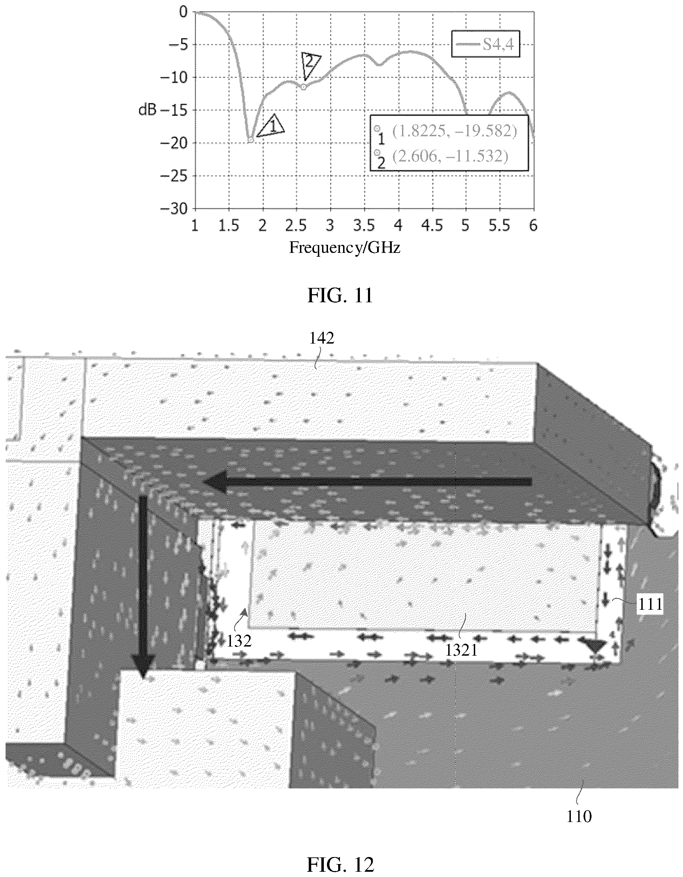

FIG. 11 and FIG. 12 show a standing wave of the second radiator 132 and a current distribution diagram of the second radiator 132 at 1.8 GHz. As partial radiators of the second radiator 132, the second transverse stub 143 and the longitudinal stub 141 of the second metal mechanical part 140 form a three-dimensional monopole and a radiator of a parasitic radiation structure, and can generate a new λ/4 fundamental mode at 1.82 GHz, so that bandwidth of the second radiator 132 can be extended.

In this embodiment of this application, a simulation test is performed on operating modes at resonance points 1.8 GHz and 2.6 GHz in FIG. 11. For example, currents of 1.8 GHz and 2.6 GHz are separately fed into the second feed point, and then current distribution on each radiation stub is observed. It is obtained through the simulation test that, at the resonance point 1.8 GHz, there is mainly a left-hand mode generated by the second transverse stub 143 and the longitudinal stub 141, and a sum of electrical lengths of the second transverse stub 143 and the longitudinal stub 141 may range from λ/8 to λ/4. At the resonance point 2.6 GHz, there is mainly a λ/4 fundamental mode generated by the third radiation stub 1321, and an electrical length of the third radiation stub 1321 may be λ/4. λ is a center frequency of a resonance frequency. For example, in FIG. 11, λ may be 1.8 GHz.

Based on the foregoing embodiment, it may be understood that the height of the longitudinal stub 141 in the thickness direction L1 of the circuit board may be less than or equal to λ/4, where λ may be a wavelength corresponding to a center frequency of a minimum resonance band.

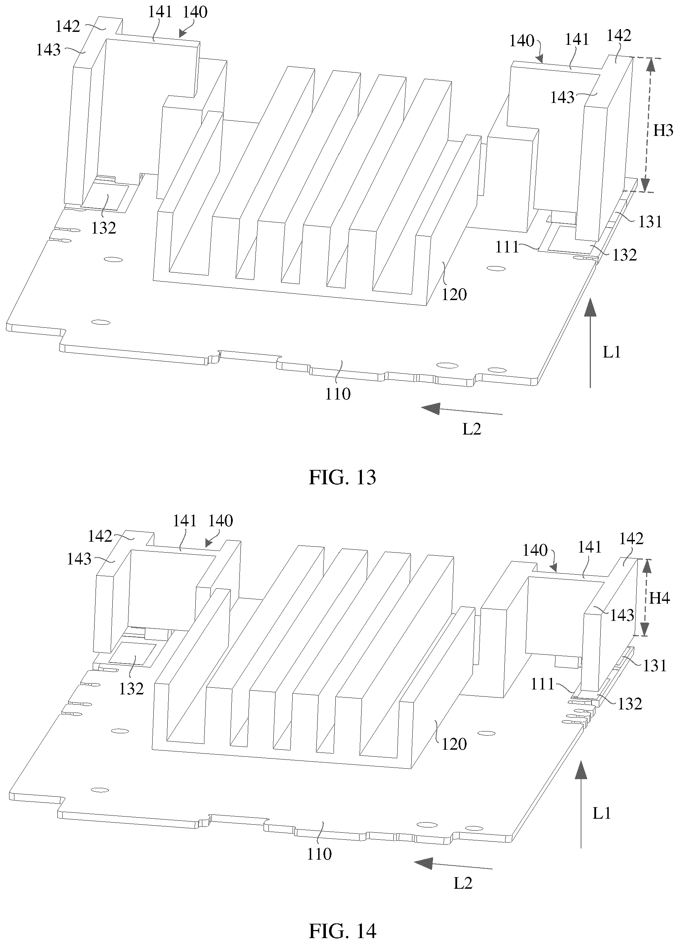

In some embodiments, the height of the longitudinal stub 141 in the thickness direction L1 of the circuit board may range from 0.5 mm to 22.5 mm. A design freedom degree of the height of the longitudinal stub 141 in the thickness direction L1 of the circuit board can facilitate regulation and control of an antenna pattern. For example, a height (namely, a first height H3) of a longitudinal stub 141 shown in FIG. 13 in the thickness direction L1 of the circuit board is greater than a height (namely, a second height H4) of a longitudinal stub 141 shown in FIG. 14 in the thickness direction L1 of the circuit board. The height of the longitudinal stub 141 in the thickness direction L1 of the circuit board is increased, so that isolation of the longitudinal stub 141 between the first radiator 131 and the second radiator 132 can be increased, and a degree of mutual interference between the first radiator 131 and the second radiator 132 can be reduced.

In some embodiments, the height of the longitudinal stub 141 in the thickness direction L1 of the circuit board may be 0.5 mm, 2 mm, 4 mm, 6 mm, 8 mm, 10 mm, 12 mm, 14 mm, 16 mm, 18 mm, 20 mm, 22 mm, 22.5 mm, an intermediate value of any two adjacent values, or the like. This is not limited in embodiments of this application.

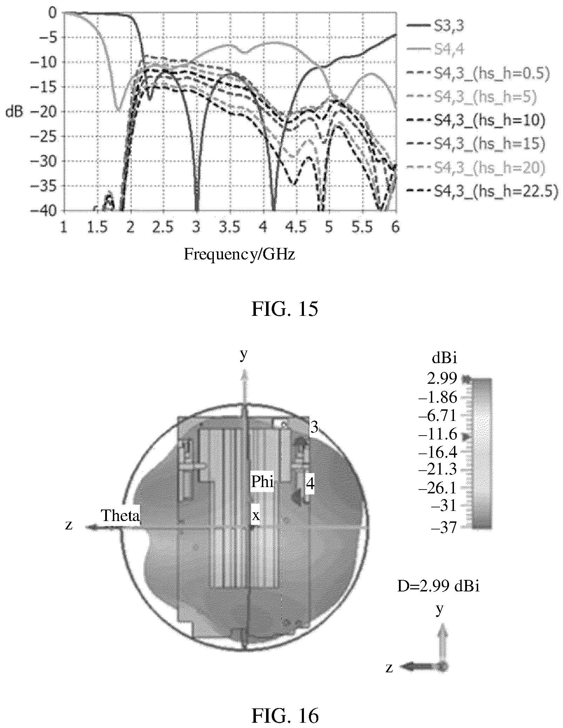

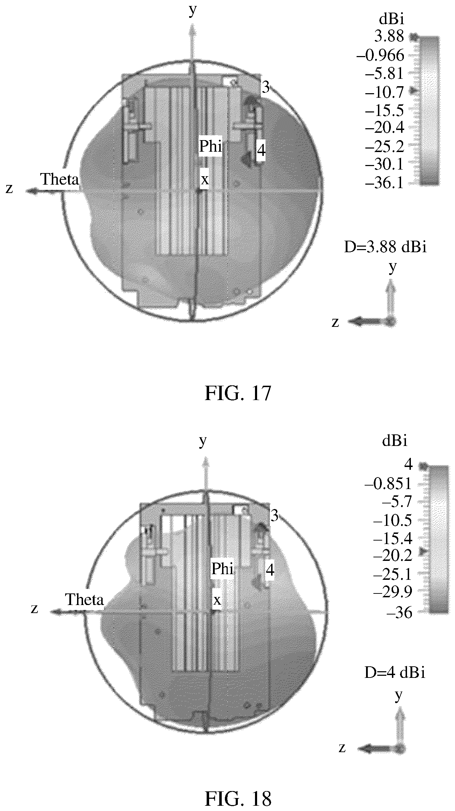

Specifically, as shown in FIG. 15, as the height of the longitudinal stub 141 in the thickness direction L1 of the circuit board increases from 0.5 mm to 22.5 mm, the isolation between the first radiator 131 and the second radiator 132 can be increased from 8 dB to 15 dB. In addition, as shown in FIG. 16, FIG. 17, FIG. 18, and FIG. 19, which are antenna patterns corresponding to different heights of the longitudinal stub 141 in the thickness direction L1 of the circuit board at a same frequency, as the height of the longitudinal stub 141 in the thickness direction L1 of the circuit board increases, reverse effect of the first transverse stub 142 and the second transverse stub 143 of the second metal mechanical part 140 on the antenna pattern gradually increases.

In embodiments of this application, a width of the clearance area 111 in a first direction L2 may be greater than or equal to 3 mm. The first direction L2 may be a length extension direction of the longitudinal stub 141, and the length extension direction of the longitudinal stub 141 is a length extension direction of the orthographic projection of the longitudinal stub 141 on the circuit board. In other words, a width of the clearance area 111 in the length extension direction of the longitudinal stub 141 may be reduced to 3 mm.

For example, in some embodiments, the width of the clearance area 111 in the first direction L2 may range from 3 mm to 15 mm. For example, the width of the clearance area 111 in the first direction L2 may be 3 mm, 4 mm, 5 mm, 6 mm, 7 mm, 8 mm, 9 mm, 10 mm, 11 mm, 12 mm, 13 mm, 14 mm, 15 mm, an intermediate value of any two adjacent values, or the like. This is not limited in embodiments of this application.

It should be noted that values and value ranges in embodiments of this application are approximate values, and an error within a specific range may exist due to impact of a manufacturing process. Persons skilled in the art may consider that the error is negligible.

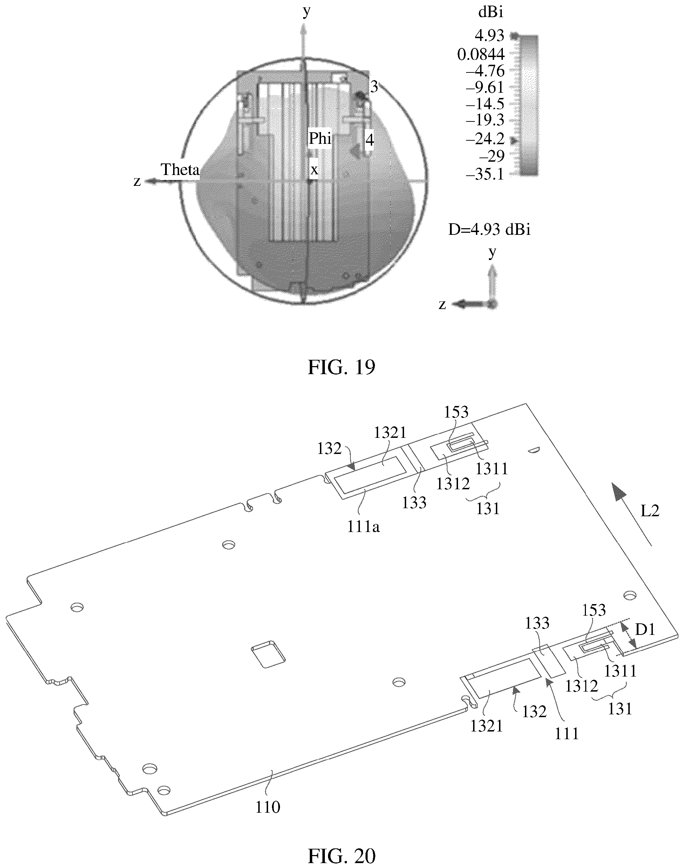

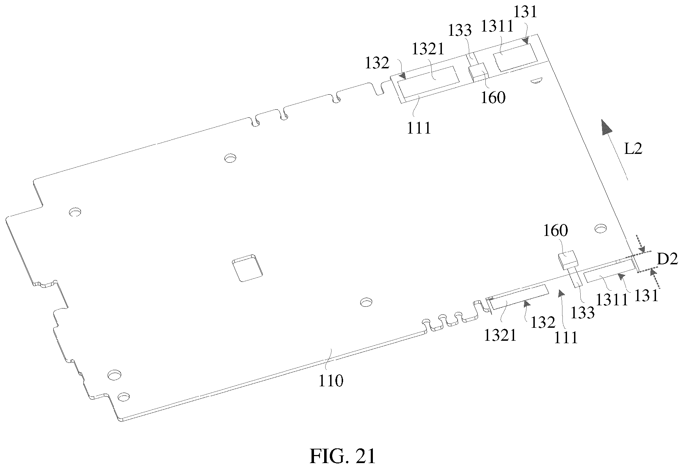

As shown in FIG. 20 and FIG. 21, a width (namely, a second width D2) of a clearance area 111 in FIG. 21 in the first direction L2 is less than a width (namely, a first width D1) of a clearance area 111 in FIG. 20 in the first direction L2. In this way, when antenna arrangement space is sufficient, a usage area of the circuit board 110 can be reduced to some extent, and larger accommodation space can be reserved for the electronic device 100.

For example, the width of the clearance area 111 in FIG. 21 in the first direction L2 is a half of the width of the clearance area 111 in FIG. 20 in the first direction L2. To be specific, a size of the clearance area 111 in FIG. 21 is reduced to 50% of a size of the clearance area 111 in FIG. 20. However, radiation performance of the antenna can still be implemented by using a structure shown in FIG. 21.

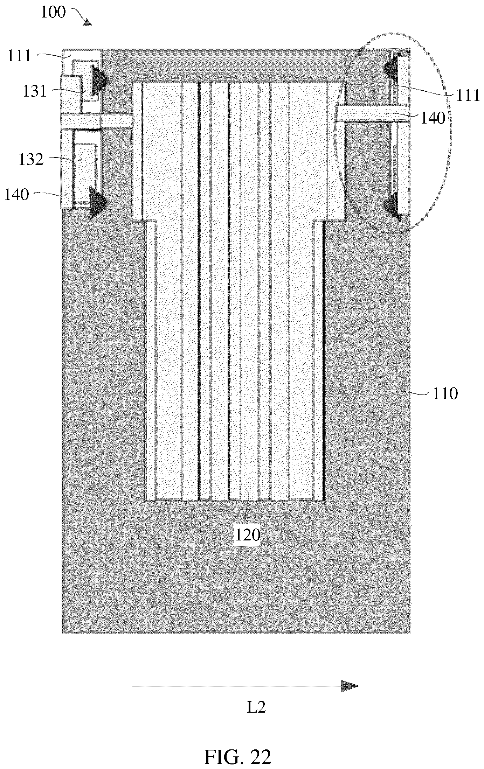

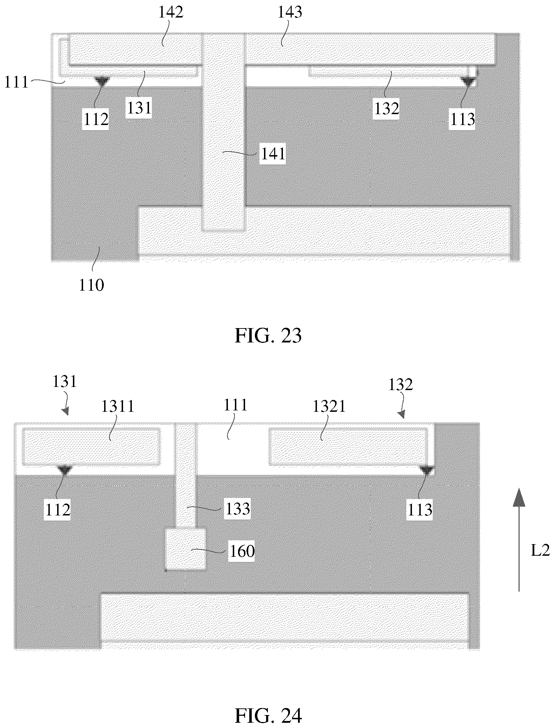

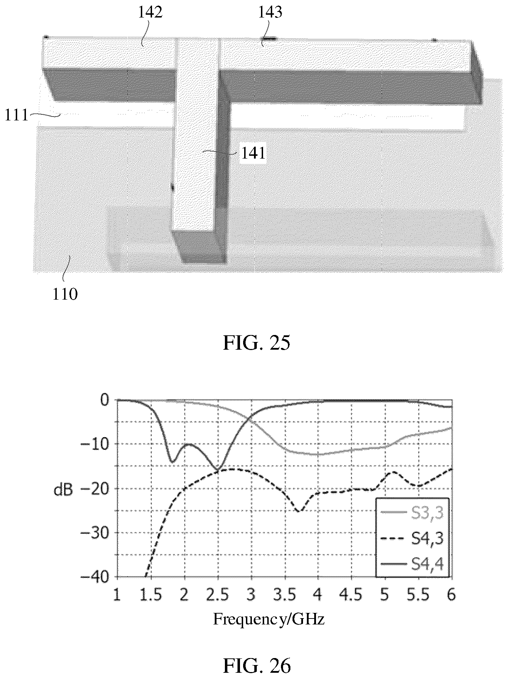

Specifically, in an actual application scenario, the first radiator 131 and the second radiator 132 may be of structures shown in FIG. 22 and FIG. 23. The first radiator 131 may include the first radiation stub 1311, and the second radiator 132 may include the third radiation stub 1321. In this case, as shown in FIG. 24 and FIG. 25, a coupling gap may be formed between the first transverse stub 142 and the first radiation stub 1311 in the thickness direction L1 of the circuit board, and a coupling gap may be formed between the second transverse stub 143 and the third radiation stub 1321 in the thickness direction L1 of the circuit board.

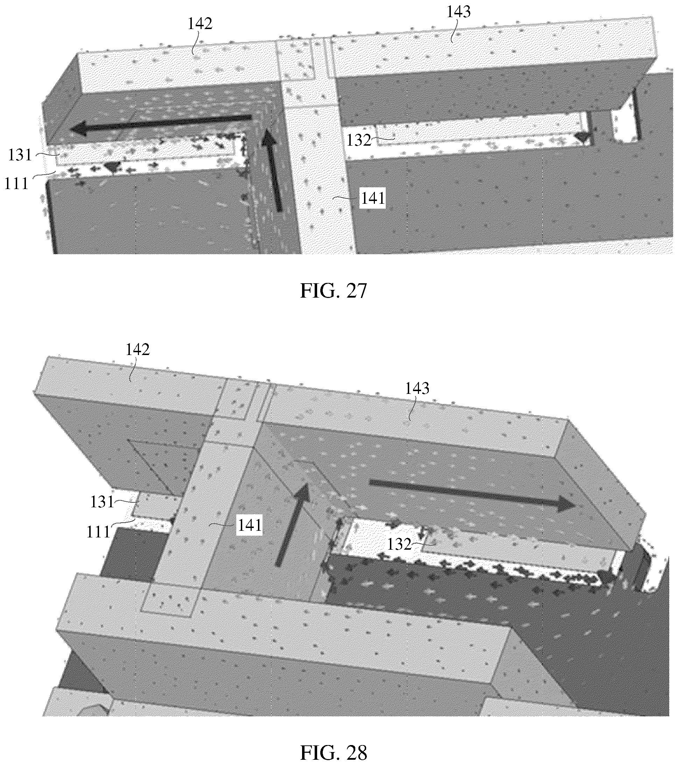

It should be noted herein that, in some embodiments, FIG. 26 and FIG. 27 show a standing wave of the first radiator 131 and a current distribution diagram of the first radiator 131 at 4.95 GHz. As partial radiators of the first radiator 131, the first transverse stub 142 and the longitudinal stub 141 of the second metal mechanical part 140 form a three-dimensional monopole and a radiator of a parasitic radiation structure, and can generate a new λ/4 fundamental mode at 3.8 GHz, so that bandwidth of the first radiator 131 can be extended.

In this embodiment of this application, a simulation test is performed on operating modes at resonance points 3.8 GHz and 5 GHz in FIG. 26. For example, currents of 3.8 GHz and 5 GHz are separately fed into the first feed point, and then current distribution on each radiation stub is observed. It is obtained through the simulation test that, at the resonance point 3.8 GHz, there is mainly a left-hand mode generated by the first transverse stub 142 and the longitudinal stub 141, and a sum of electrical lengths of the first transverse stub 142 and the longitudinal stub 141 may range from λ/8 to λ/4. At the resonance point 5 GHz, there is mainly a λ/4 fundamental mode generated by the first radiation stub 1311, and an electrical length of the first radiation stub 1311 is λ/4. λ is a center frequency of a resonance frequency. For example, in FIG. 26, λ may be 3.8 GHz.

FIG. 28 shows a standing wave of the second radiator 132 and a current distribution diagram of the second radiator 132 at 1.8 GHz. As partial radiators of the second radiator 132, the second transverse stub 143 and the longitudinal stub 141 of the second metal mechanical part 140 form a three-dimensional monopole and a radiator of a parasitic radiation structure, and can generate a new λ/4 fundamental mode at 1.82 GHz, so that bandwidth of the second radiator 132 can be extended.

In this embodiment of this application, a simulation test is performed on operating modes at resonance points 1.8 GHz and 2.5 GHz in FIG. 26. For example, currents of 1.8 GHz and 2.5 GHz are separately fed into the second feed point, and then current distribution on each radiation stub is observed. It is obtained through the simulation test that, at the resonance point 1.8 GHz, there is mainly a left-hand mode generated by the second transverse stub 143 and the longitudinal stub 141, and a sum of electrical lengths of the second transverse stub 143 and the longitudinal stub 141 may range from λ/8 to λ/4. At the resonance point 2.5 GHz, there is mainly a λ/4 fundamental mode generated by the third radiation stub 1321, and an electrical length of the third radiation stub 1321 may be λ/4. λ is a center frequency of a resonance frequency. For example, in FIG. 26, λ may be 2.5 GHz.

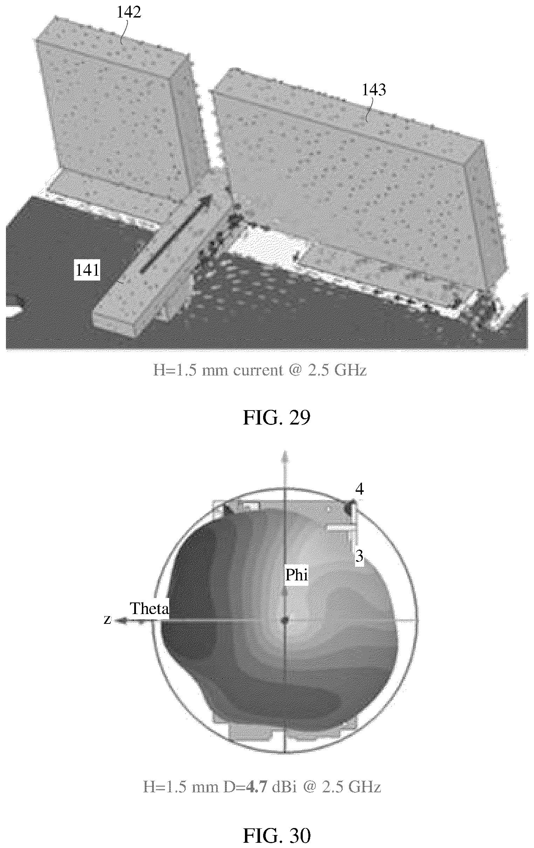

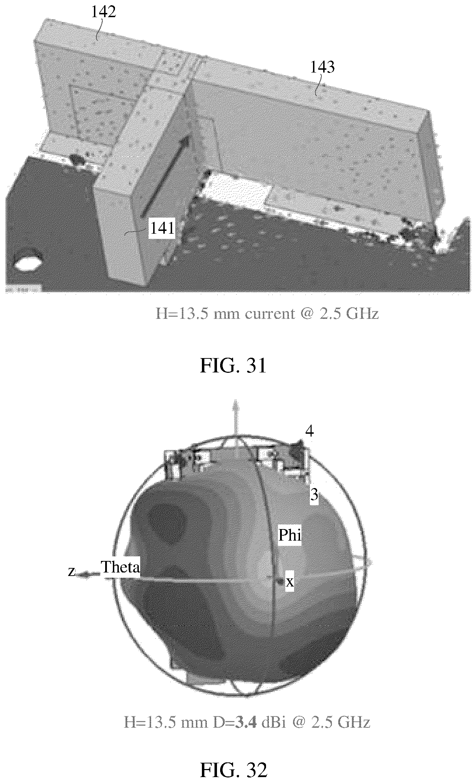

Similarly, the height of the longitudinal stub 141 in the thickness direction L1 of the circuit board may be less than or equal to λ/4, where λ may be a wavelength corresponding to a center frequency of a minimum resonance band. In some embodiments, the height of the longitudinal stub 141 in the thickness direction L1 of the circuit board may range from 0.5 mm to 22.5 mm. The height of the longitudinal stub 141 in the thickness direction L1 of the circuit board is adjusted, so that current distribution ratios of the antenna and the circuit board 110 in a horizontal direction and a vertical direction can be changed, and the antenna pattern can be effectively regulated and controlled. For example, a radiation weak field region of the pattern can be compensated for. As shown in FIG. 29 to FIG. 32, when the height of the longitudinal stub 141 in the thickness direction L1 of the circuit board increases from 1.5 mm to 13.5 mm, current intensity in the horizontal direction is clearly increased, which can compensate for a pattern dimple of the antenna in the horizontal direction, to reduce a directivity coefficient of the antenna from 4.7 dBi to 3.4 dBi.

In embodiments of this application, as shown in FIG. 3, the electronic device 100 may further include a shielding frame 170. The shielding frame 170 may be located on a periphery of the electronic component, to space the electronic component apart from at least one antenna. In addition, a side that is of the shielding frame 170 and that faces the first metal mechanical part 120 may be connected to the first metal mechanical part 120. The shielding frame 170 is disposed on the periphery of the electronic component. The shielding frame 170 has a heat dissipation function, and can also space the electronic component apart from the antenna structure and modules (for example, a component such as a chip) on the circuit board 110, to avoid impact of the electronic component on radiation performance of the antenna and operating performance of the chip, avoid adverse interference caused by radiation of the antenna to use performance of the electronic component, and eliminate cavity clutter and interference leakage to some extent.

In embodiments of this application, the electronic device 100 may further include the electronic component (not shown in the figure). The electronic component may be located between the circuit board 110 and the first metal mechanical part 120. In addition, a concave sink (not shown in the figure) may be provided on a side that is of the first metal mechanical part 120 and that faces the circuit board 110. The electronic component is in contact with a surface that is of the sink and that faces the circuit board 110. The sink concave toward the circuit board 110 is provided on the first metal mechanical part 120, and the electronic component is in contact with the surface that is of the sink and that faces the circuit board 110, so that an electrical connection path between the electronic component and the first metal mechanical part 120 can be shortened.

It may be understood that in embodiments of this application, there may be more antennas in the electronic device 100. In the electronic device 100 provided in embodiments of this application, a quantity of antennas is increased, so that the antennas in the electronic device 100 can cover more antenna modes.

In descriptions of embodiments of this application, it should be noted that, unless otherwise clearly specified and limited, the terms "installation", "connection to", and "connection" should be understood in a broad sense. For example, the connection may be a fixed connection, may be an indirect connection by using an intermediate medium, or may be an internal connection between two elements or an interaction relationship between two elements. For persons of ordinary skill in the art, specific meanings of the foregoing terms in embodiments of this application may be understood based on a specific situation.

In embodiments of this application, the foregoing terms do not indicate or imply that a described apparatus or element needs to have a particular orientation or needs to be constructed and operated in a particular orientation, and therefore cannot be construed as a limitation on embodiments of this application. In descriptions of embodiments of this application, unless otherwise specifically limited, "a plurality of" means two or more.

In the specification, claims, and accompanying drawings of embodiments of this application, the terms "first", "second", "third", "fourth", and so on (if existent) are intended to distinguish between similar objects but do not necessarily indicate a specific order or sequence. It may be understood that the data used in such a way is interchangeable in proper circumstances, so that embodiments of this application described herein can be implemented, for example, in other sequences than the sequence illustrated or described herein. In addition, the terms "may include", "have", and variants thereof are intended to cover non-exclusive inclusion. For example, a process, method, system, product, or device that includes a series of steps or units is not necessarily limited to those clearly listed steps or units, but may include other steps or units that are not clearly listed or are inherent to such a process, method, product, or device.

Finally, it should be noted that the foregoing embodiments are merely intended for describing the technical solutions of embodiments of this application other than limiting embodiments of this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. An electronic device, comprising at least:
a circuit board and a first metal mechanical part, wherein the first metal mechanical part and the circuit board are stacked and spaced apart; and
a clearance area facing inward toward the circuit board is provided on an outer edge of the circuit board;
further comprising a first radiator, wherein the first radiator is located in the clearance area, one end of the first radiator is electrically connected to a first feed point on the circuit board, and another end of the first radiator is suspended in the clearance area; and
further comprising a second metal mechanical part, wherein the second metal mechanical part is located on a periphery of the first metal mechanical part, and at least a part of an orthographic projection that is of the second metal mechanical part and that faces the circuit board is located in the clearance area; and
one end of the second metal mechanical part is electrically connected to the first metal mechanical part, and a first coupling gap exists between another end of the second metal mechanical part and the first radiator in a thickness direction of the circuit board.

2. The electronic device according to claim 1, wherein an orthographic projection that is of the first metal mechanical part and that faces the circuit board is staggered with the clearance area.

3. The electronic device according to claim 1 or 2, wherein the second metal mechanical part comprises a longitudinal stub and a first transverse stub that extend on a first plane, and the first plane is perpendicular to the thickness direction of the circuit board; and
one end that is of the longitudinal stub and that extends on the first plane is electrically connected to the first metal mechanical part, another end that is of the longitudinal stub and that extends on the first plane is connected to the first transverse stub, and the first coupling gap exists between the first transverse stub and the first radiator in the thickness direction of the circuit board.

4. The electronic device according to claim 3, further comprising a second radiator, wherein the second radiator is located in the clearance area, one end of the second radiator is electrically connected to a second feed point on the circuit board, and another end of the second radiator is suspended in the clearance area; and
the first radiator and the second radiator are spaced apart in the clearance area along a length extension direction of the first transverse stub, and the length extension direction of the first transverse stub is a length extension direction of an orthographic projection of the first transverse stub on the circuit board.

5. The electronic device according to claim 3 or 4, wherein the second metal mechanical part further comprises a second transverse stub, and orthographic projections of the first transverse stub and the second transverse stub on the circuit board are respectively located on two sides of an orthographic projection of the longitudinal stub on the circuit board; and
a second coupling gap exists between the second transverse stub and the second radiator in the thickness direction of the circuit board.

6. The electronic device according to any one of claims 3 to 5, wherein both the longitudinal stub and the first transverse stub extend in the thickness direction of the circuit board.

7. The electronic device according to claim 5, wherein the second transverse stub extends in the thickness direction of the circuit board.

8. The electronic device according to claim 5, further comprising an isolation stub, wherein one end of the isolation stub is located in the clearance area, the isolation stub extends between the first radiator and the second radiator, another end of the isolation stub is grounded through the circuit board, and a spacing exists between the isolation stub and each of the first radiator and the second radiator.

9. The electronic device according to claim 8, wherein in the thickness direction of the circuit board, the isolation stub is opposite to the longitudinal stub, and a gap exists between the isolation stub and the longitudinal stub; and the longitudinal stub and the isolation stub are electrically connected through a conductive structure.

10. The electronic device according to any one of claims 3 to 9, wherein the first radiator comprises at least a first radiation stub;
one end of the first radiation stub is electrically connected to the first feed point, and another end of the first radiation stub is suspended in the clearance area; and
the first coupling gap is formed between the first transverse stub and the first radiation stub.

11. The electronic device according to claim 10, wherein the first radiator further comprises a second radiation stub coupled to the first radiation stub;
one end of the second radiation stub is grounded through the circuit board, and another end of the second radiation stub is suspended in the clearance area; and
the first coupling gap is formed between the first transverse stub and at least one of the first radiation stub and the second radiation stub, and a third coupling gap is formed between the first radiation stub and the second radiation stub.

12. The electronic device according to any one of claims 5 to 9, wherein the second radiator comprises a third radiation stub;
one end of the third radiation stub is electrically connected to the second feed point, and another end of the third radiation stub is suspended in the clearance area; and
the second coupling gap is formed between the second transverse stub and the third radiation stub.

13. The electronic device according to any one of claims 3 to 12, wherein a height of the longitudinal stub in the thickness direction of the circuit board is less than or equal to λ/4, and λ is a wavelength corresponding to a center frequency of a minimum resonance band.

14. The electronic device according to any one of claims 5 to 9, wherein the first transverse stub and the second transverse stub are higher than the first metal mechanical part in the thickness direction of the circuit board.

15. The electronic device according to any one of claims 5 to 9, wherein a length of the second transverse stub is greater than a length of the first transverse stub.

16. The electronic device according to any one of claims 3 to 15, wherein a width of the clearance area in a first direction is greater than or equal to 3 mm; and
the first direction is a length extension direction of the longitudinal stub, and the length extension direction of the longitudinal stub is a length extension direction of the orthographic projection of the longitudinal stub on the circuit board.

17. The electronic device according to any one of claims 1 to 15, further comprising an electronic component, wherein
the electronic component is located between the circuit board and the first metal mechanical part; and
A concave sink is provided on a side that is of the first metal mechanical part and that faces the circuit board, and the electronic component is in contact with a surface that is of the sink and that faces the circuit board.

18. The electronic device according to claim 17, further comprising a shielding frame, wherein the shielding frame is located on a periphery of the electronic component, to space the electronic component apart from the at least one antenna; and
a side that is of the shielding frame and that faces the first metal mechanical part is connected to the first metal mechanical part.

19. The electronic device according to claim 17 or 18, wherein the first metal mechanical part and the second metal mechanical part are heat sinks; and
the electronic component is a heat-emitting component.

20. The electronic device according to any one of claims 1 to 19, wherein the electronic device is customer premise equipment.
